Europäisches Patentamt

European Patent Office

Office européen des brevets

(11) Numéro de publication: **0 484 852 A1**

# DEMANDE DE BREVET EUROPEEN

(21) Numéro de dépôt: **91118765.6**

(22) Date de dépôt: **04.11.91**

(51) Int. Cl.5: **H05B 3/26, H05K 7/20**

(30) Priorité: **07.11.90 FR 9013803**

(43) Date de publication de la demande:
**13.05.92 Bulletin 92/20**

(84) Etats contractants désignés:
**DE FR GB IT**

(71) Demandeur: **ALCATEL ESPACE**
**11, avenue Dubonnet**
**F-92407 Courbevoie Cédex(FR)**

(72) Inventeur: **Youssef, Abdul**
**2, rue Jean-Jacques Rousseau**
**F-94190 Villeneuve Saint Georges(FR)**
Inventeur: **Ducrocq, Jean-Bernard**
**10 chemin Jaqui, Pechabou**
**F-31320 Castanet Tolosan(FR)**
Inventeur: **Meyer, Alain, c/o CNET-CRPE**
**38-40, rue du Général Leclerc**
**F-92131 Issy Les Moulineaux(FR)**

(74) Mandataire: **Weinmiller, Jürgen et al**
**Lennéstrasse 9 Postfach 24**
**W-8133 Feldafing(DE)**

(54) **Circuit électronique contrôlé en température.**

(57) L'invention concerne un circuit électronique contrôlé en température comportant un substrat support, sur sa première face, des composants (13) dudit circuit et, sur sa seconde face d'un réseau de réchauffage (12).

Application notamment au domaine des télécommunications spatiales.

FIG.1

EP 0 484 852 A1

Rank Xerox (UK) Business Services
(-/2.19/2.0)

L'invention concerne un circuit électronique contrôlé en température.

Comme décrit dans le "cours de Technologie spatiale" ("La Technologie des expériences scientifiques spatiales" ; "L'environnement des expériences sur le véhicule en orbite" par P. Mauroy ; le CNES, 1981). Les équipements électroniques embarqués à bord des satellites ne peuvent fonctionner, sans risque de destruction, que dans des conditions de température convenables, en fonctionnement et en stockage.

Ces conditions sont d'autant plus difficiles à satisfaire que les équipements électroniques se trouvent montés à l'extérieur du satellite, sur un bras par exemple. En effet, dans les cas d'éclipses de longue durée, il est nécessaire de maintenir la température des équipements au-dessus d'une limite donnée, pour assurer la survie des composants électroniques.

Les moyens de contrôle thermique passif utilisés habituellement, comme décrit dans le "Cours de technologie spatiale" (1981 ; "la technologie des expériences spatiales", le CNES ; "Le contrôle thermique des expériences spatiales" par A. Rolfo), (tels que des revêtements de différentes catégories, des matelas isolants multi-couches...), s'avèrent parfois insuffisants dans les cas de variations importantes des énergies reçues. Il est alors nécessaire d'utiliser des moyens de contrôle thermique actifs consistant à dissiper une certaine puissance variable à l'intérieur des équipements concernés.

Il est également connu de coller sur le module à contrôler des films résistifs flexibles dissipant la puissance d'appoint nécessaire. Mais cette solution ne s applique pas aux circuits hybrides à haut degré d'intégration.

L'invention a pour objet de résoudre ce problème de contrôle thermique.

Elle propose à cet effet un circuit électronique contrôlé en température comportant un substrat support, sur sa première face, des composants du circuit électronique, caractérisé en ce que ledit substrat comprend, sur sa seconde face, un réseau de réchauffage.

Avantageusement un tel circuit est obtenu en appliquant une technique de fabrication connue et facilement reproductible, permettant un contrôle thermique actif facilement ajustable et dimensionnable, intégré au sein du substrat du composant hybride.

Cette technique a été étudiée et développée pour être intégrée en cours de chaîne de fabrication de circuits hybrides. On obtient ainsi un haut rendement thermique, une grande facilité de mise en oeuvre, et un gain de poids et d'encombrement.

Les caractéristiques et avantages de l'invention ressortiront d'ailleurs de la description qui va suivre, à titre d'exemple non limitatif, en référence aux figures annexées sur lesquelles :

- la figure 1 illustre schématiquement le circuit hybride de l'invention ;

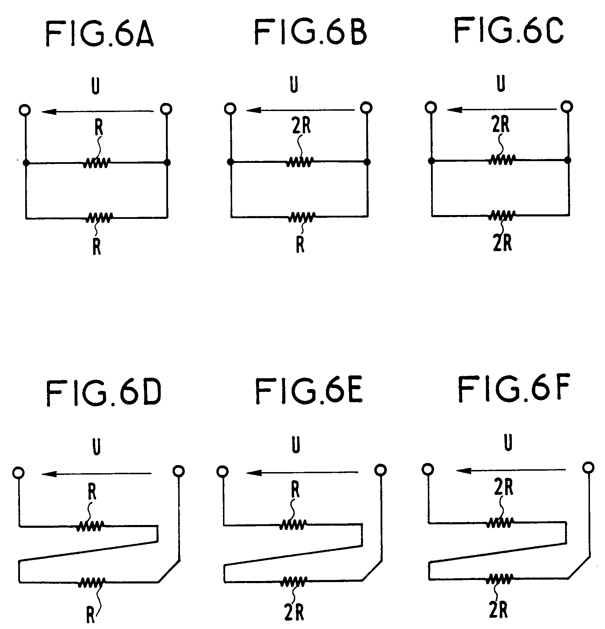

- les figures 2 à 8 illustrent diverses réalisations du circuit hybride de l'invention.

L'invention porte sur l'incorporation sur la face arrière 10B d'un circuit électronique, par exemple en technologie hybride, embarqué sur satellite de moyens nécessaires au contrôle thermique.

Ces moyens consistent en une sérigraphie sur le substrat 10 du circuit 11 d'un réseau 12 de réchauffage résistif cellulaire compensé, assurant la puissance d'appoint nécessaire, la face avant 10A du substrat étant celle qui porte le circuit en lui-même 13 et donc les composants 14 qui le composent. Ce réseau 12 peut être connecté à une thermistance indiquant la température du circuit.

Le mode du montage série/parallèle du réseau, la possibilité d'ajuster au laser la valeur ohmique élémentaire, ainsi que la possibilité de choisir l'encre résistive convenable, offrent une grande souplesse pour obtenir la puissance d'appoint nécessaire.

La sérigraphie du réseau est telle que les circulations de courant à l'intérieur se compensent mutuellement, réduisant ainsi le rayonnement électro-magnétique.

L'invention permet notamment :
- l'intégration sur le support du circuit électronique des moyens nécessaires au contrôle thermique,
- la compensation des effets électromagnétiques engendrés,
- la haute rédondance de fonctionnement.

Dans un exemple de réalisation d'un macro-composant hybride intégrant les protections contre les radiations et le contrôle thermique, ont été développés deux types d'implantation du réseau chauffant : une configuration série, et une autre parallèle.

L'idée de base consiste à dissiper une énergie donnée dans une résistance R alimentée par une tension U : La puissance nominale dissipée étant donc $p = U^2/R$. La résistance R est réalisée par la sérigraphie d'une encre résistive sur le dos du substrat du circuit.

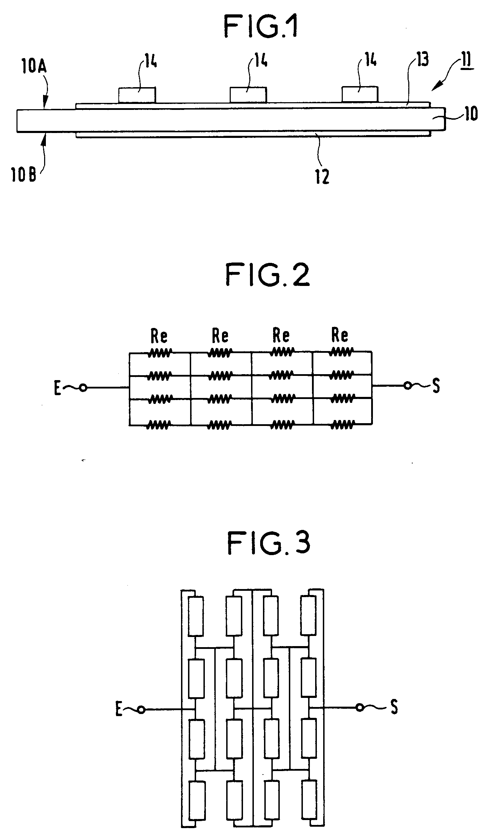

Pour avoir une distribution homogène de l'énergie dissipée, et pour assurer un bon niveau de fiabilité du procédé, on réalise la résistance R par une cellule résistive redondante d'ordre 16 par exemple. Comme représenté par la figure 2, seize résistances élémentaires, de valeur ohmique Re, sont disposées parallèlement en groupe de 4. La résistance équivalente de la cellule est R = Re. Le dessin de la cellule élémentaire représenté sur la figure 3 est tel que les perturbations magnétiques engendrées par le courant y circulant soient compensées.

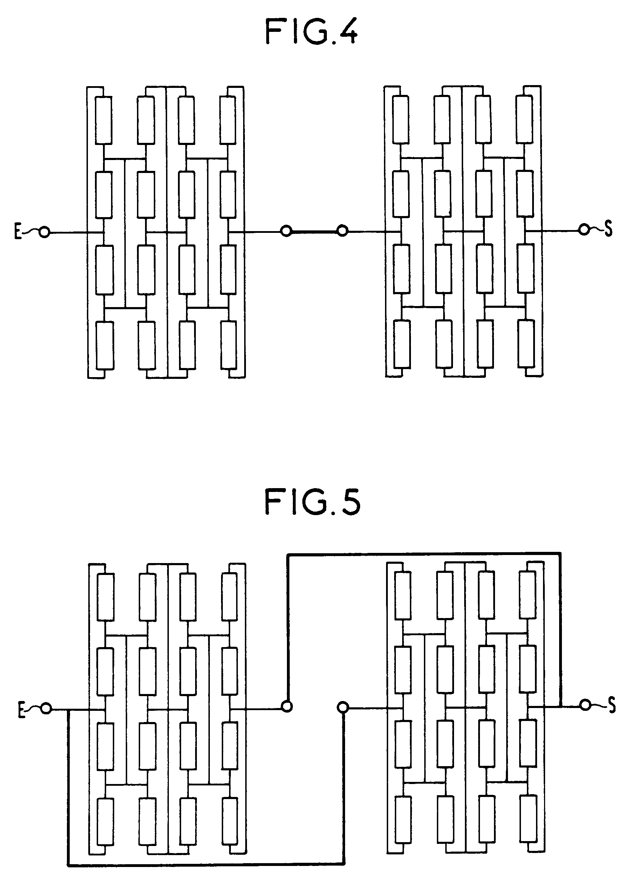

Le réseau de réchauffage complet est constitué de deux cellules redondantes compensées, par exemple. Selon le mode de montage de ces deux cellules on a, soit un réseau-série représenté à la figure 4, de puissance

dissipée : 0,5 p, soit un réseau-parallèle comme représenté à la figure 5, de puissance dissipée : 2 p. Selon le mode de raccordement série/parallèle des cellules, et en tirant bénéfice de l'ajustage au laser des résistances sérigraphiées, on peut, à partir d'une valeur ohmique élémentaire Re, couvrir une large plage des valeurs de puissance à fournir.

Ainsi, selon le mode de montage du réseau micro-réchauffeur, et en ajustant au laser la valeur ohmique de chaque résistance sérigraphiée, on peut dissiper différentes valeurs de puissance :
- figure 6A : P = 2 p
- figure 6B : P = 1,5 p
- figure 6C : P = p
- figure 6D : P = 0,5 p
- figure 6E : P = 0,33 p
- figure 6F : P = 0,25 p

avec p (puissance dissipée dans la résistance R) = $U^2/R$

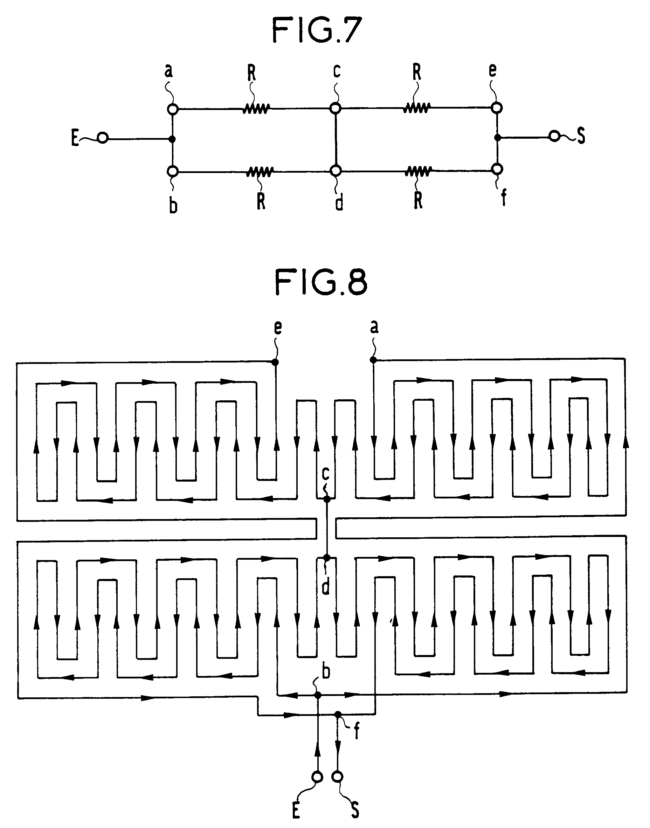

Il existe de nombreuses possibilités de variantes fonctions de :
- l'architecture de compensation du réseau ;
- l'ordre de rédondance de chaque cellule ;
- le choix de la résistivité de l'encre utilisée ;
- la technique de sérigraphie : couches épaisses, ou couches minces ;
- la façon de réaliser la résistance de chauffage : pavés avec de l'encre résistive, ou pistes conductrices : ainsi les figures 7 et 8 représentent un réseau chauffant compensé sérigraphié avec de l'encre conductrice.

Dans une procédure de fabrication du circuit de l'invention en technologie hybride, on sérigraphie le réseau de résistance en une seule passe avec de l'encre qualifiée ; la valeur obtenue étant 5 K $\Omega$ ± 10 %. Cette procédure répond aux exigences spatiales. La liaison entre la face composant et le réseau de résistance est réalisé par une liaison or sur le champ du substrat. Le substrat câblé est reporté dans un boîtier par exemple en Kovar Nickelé par un collage au film. Il est polymérisé à 150 °C.

Le circuit selon l'invention présente donc de nombreux avantages et notamment :
- un rendement thermique élevé,
- une compensation du rayonnement électro-magnétique,
  une rédondance élevée,
- une technique versatile,
- un faible coût.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

**Revendications**

1. Circuit électronique contrôlé en température comportant un substrat (10) support, sur sa première face (10a), des composants (13) dudit circuit, caractérisé en ce que ledit support comprend, sur sa seconde face (10b), un réseau de réchauffage (12).

2. Circuit électronique selon la revendication 1, caractérisé par le fait que ce réseau de réchauffage (12) est un réseau résistif.

3. Circuit électronique selon la revendication 2, caractérisé en ce que le réseau résistif (12) est tel que les circulations de courant se compensent mutuellement, réduisant ainsi le rayonnement électro-magnétique.

4. Circuit électronique selon la revendication 3, caractérisé en ce que ce réseau résistif (12) est réalisé en encre résistive.

5. Circuit électronique selon la revendication 4, caractérisé en ce que le réseau résistif (12) est un réseau cellulaire.

6. Circuit électronique selon la revendication 5, caractérisé en ce que le réseau cellulaire (12) comprend des cellules en rédondance.

7. Circuit électronique selon l'une quelconque des revendications précédentes, caractérisé en ce qu'il comprend une thermistance connectée au réseau de réchauffage (12).

8. Circuit électronique selon l'une quelconque des revendications précédentes, caractérisé en ce qu'il est réalisé en technologie hybride.

9. Circuit électronique selon l'une quelconque des revendications précédentes, caractérisé en ce qu'il est embarqué sur satellite.

# FIG.1

# FIG.2

# FIG.3

# FIG.4

# FIG.5

FIG.6A

U

R

R

FIG.6B

U

2R

R

FIG.6C

U

2R

2R

FIG.6D

U

R

R

FIG.6E

U

R

2R

FIG.6F

U

2R

2R

# FIG.7

# FIG.8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 301 290  (SIEMENS)<br>* figures 1,2; revendications 1-4;<br>colonne 1, ligne 34 - colonne 2, ligne<br>1 *<br>--- | 1,2,8 | H 05 B    3/26<br>H 05 K    7/20 |
| A | EP-A-0 356 087  (ILLINIOS TOOL)<br>* figures 1-3; colonne 2, ligne 47 -<br>colonne 4, ligne 16 *<br>--- | 1,2,4,5<br>,7,8 | |
| A | EP-A-0 334 824  (KANTHAL)<br>* en entier *<br>--- | 1-3,5,6 | |
| A | FR-A-2 510 803  (LICENTIA)<br>* figure 1; revendications 1-8 *<br>----- | 1,2,7,8 | |

**DOMAINES TECHNIQUES RECHERCHES (Int. Cl.5)**

H 05 B    3/00
H 05 K    7/20

Le présent rapport a été établi pour toutes les revendications

| Lieu de la recherche | Date d'achèvement de la recherche | Examinateur |
|---|---|---|
| BERLIN | 13-02-1992 | HAHN G |